# EUROPEAN PATENT APPLICATION

(11) **EP 2 947 175 A1**
(43) Date of publication of application: **25.11.2015**
(21) Application number: 14169207.9
(22) Date of filing: 21.05.2014
(51) Int. Cl.: C23C 14/14, C23C 14/34, H01J 37/34, C22C 9/02, C22C 9/04, C22C 18/02, C23C 14/58, H01L 31/00

(54) **CuSn, CuZn and Cu2ZnSn sputter targets**

(71) Applicant: Heraeus Deutschland GmbH & Co. KG, 63450 Hanau (DE)
(72) Inventor: Simons, Christoph, 63599 Biebergemünd (DE); Schultheis, Markus, 36103 Flieden (DE)
(74) Representative: Kühn, Hans-Christian

(57) **Abstract**

The invention claims a three dimensional sputter target comprising CuZnSn material, CuZn material or CuSn material. Exemplary has a CuZnSn material a Cu content ranging from 40 atomic percent to 60 atomic percent; a Zn content ranging from 20 atomic percent to 30 atomic percent; and a Sn content ranging from 20 atomic percent to 30 atomic percent, wherein the three dimensional sputter target has at least one principal axis dimension greater than 500 mm and the CuZnSn material has a grain size ranging from 0.005 mm to 5 mm. Additional to that claims the invention a method of producing the three dimensional sputter target.

## Description

### FIELD

The present disclosure relates to CuZn, CuSn or Cu₂ZnSn compositions for sputter targets.

### BACKGROUND

Aside from CdTe and amorphous/microcrystalline Si absorber systems, especially chalcopyrite-like systems such as Cu(In, Ga)(Se, S)₂ have become established in the thin-film photovoltaics industry. These absorber systems currently show the best potential to achieve high cell efficiencies.

New absorber system based on kesterite-like systems such as Cu₂ZnSn(Se, S)₄ work without the need to use the expensive raw materials, indium and gallium. The raw materials, Cu, Zn, and Sn, are available in sufficient quantities and inexpensively. For production of said absorber systems, vaporization and sputtering technologies are being considered that first apply a metallic CuZnSn alloying system which is then reacted with Se and/or S in a subsequent procedural step.

Basic sputtering experiments are described in Electrochem. Solid-State Lett. 2010 13(11): H379-H381 using small scale targets, e.g., diameter of 60 mm, applied in sputter laboratories. Herewith, only small substrates of some few cm² can be coated for R&D purposes. In these cases inhomogeneities within the targets with respect to chemistry, gas contents, porosity, microcracks, grain size, phase segregation, electrical conductivity, are of less importance as their impact on the small scale substrate becomes indistinct and negligible. However industrial scale sputter processes need large targets of lengths up to 4 m, widths 24 cm, or diameters 16 cm with homogeneity in chemical composition and microstructure, and electrical conductivity over full length and volume in order to ensure a smooth and stable sputter plasma, uniform layer deposition, and uniform layer characteristics. Otherwise the inhomogeneity of the sputter target will be copied to the sputtered layers.

The present disclosure addresses sputter targets for the production of kesterite-like absorber systems Cu₂ZnSn (Se, S)₄ through sputtering technology.

### BRIEF SUMMARY

In one embodiment, a three dimensional sputter target is provided for comprising a CuZnSn material having a Cu (copper) content ranging from 40 atomic percent to 60 atomic percent, a Zn (zinc) content ranging from 20 atomic percent to 30 atomic percent and a Sn (tin) content ranging from 20 atomic percent to 30 atomic percent, wherein the three dimensional sputter target has at least one principal axis dimension greater than 500 mm and wherein the CuZnSn material has a grain size ranging from 0.005 mm to 5 mm.

In another embodiment, a three dimensional sputter target is provided for comprising a CuZn material having a Cu content ranging from 40 atomic percent to 60 atomic percent and a Zn content ranging from 40 atomic percent to 60 atomic percent, wherein the three dimensional sputter target has at least one principal axis dimension greater than 500 mm and wherein the CuZn material has a grain size ranging from 0.005 mm to 5 mm.

In yet another embodiment, a three dimensional sputter target is provided for comprising a CuSn material having a Cu content ranging from 40 atomic percent to 60 atomic percent and a Sn content ranging from 40 atomic percent to 60 atomic percent, wherein the three dimensional sputter target has at least one principal axis dimension greater than 500 mm and wherein the CuSn material has a grain size ranging from 0.005 mm to 5 mm. In another embodiment, the material of a planar and/or tube-shaped target material has an alkali compound, preferably a sodium compound, with a content of the alkali metal in the target material ranging from 0 atomic percent to 25 atomic percent, preferably from 5 atomic percent to 20 atomic percent. In still yet another embodiment, the material of a three dimensional sputter target further comprises an alkali compound, preferably a Na₂SO₃, Na₂SeO₃ or NaF content, ranging from 0 mol% to 25 mol%, preferably ranging from 5 mole percent to 20 mole percent. In one such embodiment, the three dimensional sputter target is a planar and/or tube-shaped target material.

In some embodiments, the three dimensional sputter target has a shape corresponding to a tube, a disk, a plane, a tile, a cylinder or a combination of these.

In some embodiments, the three dimensional sputter target has a tube shape having a length ranging from 500 mm to 4000 mm and a diameter ranging from 100 mm to 200 mm.

In some embodiments, the three dimensional sputter target has a planar shape having a length ranging from 500 mm to 4000 mm, a width ranging from 70 mm to 300 mm and a thickness ranging from 3 mm to 50 mm.

In some embodiments, the three dimensional sputter target has a planar shape having a length ranging from 500 mm to 4000 mm, a width ranging from 70 mm to 300 mm and a thickness ranging from 3 mm to 50 mm comprised of a plurality of tiles shape, each tile having a length ranging from 100 mm to 300 mm, a width ranging from 70 mm to 300 mm and a thickness ranging from 3 mm to 50 mm.

In some embodiments, the three dimensional sputter target has a cylinder shape comprised of a plurality of segments, wherein the three dimensional target has an outer diameter ranging from 100 mm to 200 mm, an inner diameter ranging from 70 mm to 180 mm and a length ranging from 500 mm to 4000 mm and where each segment has an outer diameter ranging from 100 mm to 200 mm, an inner diameter ranging from 70 mm to 180 mm and a length ranging from 100 mm to 750 mm.

Regarding above mentioned sizes of the embodiments one main idea of the invention is to produce targets with a great size. So it is possible to produce targets e.g. with a lengh up to 4000 mm. But the possible sizes itself have no impact on the strucutre of the material of the target. That means, that a target e.g. with a lengh of 500 mm has the same or similar structure as the target has a lengh of 4000 mm. So, a main solution of the invention is to have the option to produce great sizes of targets, e.g. targets with a size up to 4000 mm.

In some embodiments, the CuZnSn, CuZn and/or CuSn materials have a homogeneous microstructure. In some such embodiments, at least 75 % of the grains of the CuZnSn, CuZn and/or CuSn materials are of a size in a range of +/-70%, preferably +/-50% of a mean grain size range in the principal axis dimension. In some such embodiments, the CuZnSn, CuZn and/or CuSn materials have mean grain size ranging from 0.05 mm to 0.5 mm. In other such embodiments, the CuZnSn, CuZn and/or CuSn materials have mean grain size ranging from 0.5 mm to 5.0 mm.

In still yet other embodiments, the homogeneous microstructure of the CuZnSn, CuZn and/or CuSn materials is characterized by the material density ranging from: 80-99 %, 85-99 %, 90-99 %, 95-99 % or 98-99 % each of theoretical density.

In other embodiments, a method of producing the three dimensional sputter target is provided for, comprising the steps of: melt mixing Cu with one or more of Zn and Sn at a temperature above the melting point of the mixture; transferring the mixture to a preheated mold; and cooling the mixture to thereby form a three dimensional shaped structure. In this embodiment neither mechanically alloying nor mechanically mixing is preferably conducted. In one embodiment, the method further comprises the step of applying the three dimensional shaped structure to a target support to form the three dimensional sputter target.

In yet other embodiments, a method of producing the three dimensional sputter target is provided for, comprising the steps of: providing a powder mixture of Cu with one or more of Zn and Sn; compressing the powder mixture to thereby form a three dimensional shaped structure, wherein the compressing is accomplished by axial compressing or cold-isostatic compressing. In this embodiment only mechanically mixing is preferably conducted.

In one embodiment, an alkali compound powder, preferably a Na₂SO₃, Na₂SeO₃ or NaF powder, is added to the powder mixture of Cu with one or more of Zn and Sn, to thereby by form a powder mixture comprising a powder mixture of Cu with one or more of Zn and Sn and the alkali compound. In this embodiment with the alkali compound powder the powder mixture of Cu with one or more of Zn and Sn and the alkali compound powder are preferably mechanically alloyed and/or mechanically mixed.

In one embodiment, the method further comprising the step of; sintering the compressed mixture.

In still yet other embodiments, a method of producing the three dimensional sputter target is provided for, comprising the steps of: providing a mixture of Cu with one or more of Zn and Sn; spraying the mixture onto a rotating target support to thereby form three dimensional sputter target, wherein the spraying is accomplished by a technique selected from the group consisting of: cold gas spraying, plasma spraying or arc spraying. In some embodiments, the mixture has a powder form or a wire form or is an alloy.

In still yet other embodiments, a method of producing the three dimensional sputter target is provided for comprising the steps of: melting Cu with one or more of Zn and Sn; spraying the melted mixture towards a rotating target support to thereby form three dimensional sputter target, wherein the spraying is performed in a vacuum or an inert gas.

Cu with one or more of Zn and Sn means, that combinations like CuSn, CuZn, CuSnZn or CuZnSn are possible, wherein the percentages of the elements in the prior mentioned formulas are named generally as examples only.

### DETAILED DESCRIPTION

In the simplest case, Cu₂ZnSn layers are vaporized or sputtered using the elements, Cu, Zn and Sn. The homogenization of the elements in the Cu₂ZnSn alloying system can be improved through the use of alloying targets based on CuZn, CuSn, Cu₂ZnSn. The alloys used in this context, are bronzes with a high Sn content and brasses with a high Zn content, all of high purity. Due to the requirements of high purity and the brittleness coming from the high content of intermetallic phases they are not commercially available. Moreover, CuZnSn alloys can be used as well, but also are of no technical significance owing to the requirement of high purity and to their high brittleness and are not commercially available for this reason.

The present disclosure provides for various embodiments of a three dimensional sputter target. In one embodiment, the three dimensional sputter target includes a Cu₂ZnSn material. The Cu₂ZnSn material may have: (i) Cu content ranging from: 40 atomic percentage ("at. %") to 60 at. %, 45 at. % to 55 at.%, 40 at.% to 50 at.% or 50 at.% to 60 at.%; (ii) Zn content ranging from 20 at. % to 30 at. %, 20 at. % to 25 at. % or 25 at. % to 30 at. %, and (iii) Sn content ranging from 20 at. % to 30 at. %, 20 at. % to 25 at. % or 25 at. % to 30 at. %. In one embodiment, the Cu₂ZnSn material has a composition of 25 at. % Zn ± 2 at. %, 25 at. % Sn ± 2 at. % and the remainder being Cu. The oxygen content of the Cu₂ZnSn material depends on the method of manufacture. In some embodiments, the oxygen content is: less than 100 ppm, less than 250 ppm, less than 500 ppm, less than 1000 ppm, less than 2500 ppm or less than 5000 ppm. In some embodiments, the Cu₂ZnSn material has a metallic purity of at least 99.9 %. In other embodiments, the Cu₂ZnSn material has a metallic purity of at least 99.99 %.

In still yet another embodiment, the Cu₂ZnSn material further comprises an alkali compound, preferably a Na₂SO₃, Na₂SeO₃ or NaF content, ranging from 0 mol% to 25 mol%, preferably ranging from 5 mole percent to 20 mole percent. In one such embodiment, such material is formed as a three dimensional sputter target. In another such embodiment, the material is formed as a planar and/or tube-shaped target shape. In another embodiment, the Cu₂ZnSn material is mechanically alloyed or mechanically mixed to an alkali compound, preferably a sodium compound, in such a way that the content of the alkali metal in the target material ranges from 0 atomic percent to 25 atomic percent preferably from 5 atomic percent to 20 atomic percent. In one such embodiment, the material is formed as a planar and/or tube-shaped target shape.

In another embodiment, the three dimensional sputter target includes a CuZn material. The CuZn material may have: (i) Cu content ranging from: 40 atomic percentage ("at. %") to 60 at. %, 45 at. % to 55 at.%, 40 at.% to 50 at.% or 50 at.% to 60 at.%; and (ii) Zn content ranging from 40 at. % to 60 at. %, 45 at. % to 55 at.%, 40 at.% to 50 at.% or 50 at.% to 60 at. %. In one embodiment, the CuZn material has a composition of 50 at. % Zn ± 2 at. % and the remainder being Cu. The oxygen content of the CuZn material depends on the method of manufacture. In some embodiments, the oxygen content is: less than 100 ppm, less than 250 ppm, less than 500 ppm, less than 1000 ppm, less than 2500 ppm or less than 5000 ppm. In some embodiments, the CuZn material has a metallic purity of at least 99.9 %. In other embodiments, the CuZn material has a metallic purity of at least 99.99 %.

In still yet another embodiment, the CuZn material further comprises an alkali compound, preferably a Na₂SO₃, Na₂SeO₃ or NaF content, ranging from 0 mol% to 25 mol%, preferably ranging from 5 mole percent to 20 mole percent. In one such embodiment, such material is formed as a three dimensional sputter target. In another such embodiment, the material is formed as a planar and/or tube-shaped target shape. In another embodiment, the CuZn material is mechanically alloyed or mechanically mixed to an alkali compound, preferably a sodium compound, in such a way that the content of the alkali metal in the target material ranges from 0 atomic percent to 25 atomic percent preferably from 5 atomic percent to 20 atomic percent. In one such embodiment, the material is formed as a planar and/or tube-shaped target shape.

In another embodiment, the three dimensional sputter target includes a CuSn material. The CuSn material may have; (i) Cu content ranging from: 40 atomic percentage ("at. %") to 60 at. %, 45 at. % to 55 at.%, 40 at.% to 50 at.% or 50 at.% to 60 at.%; and (ii) Sn content ranging from 40 at. % to 60 at. %, 45 at. % to 55 at.%, 40 at.% to 50 at.% or 50 at.% to 60 at. %. In one embodiment, the CuSn material has a composition of 50 at. % Sn ± 2 at. % and the remainder being Cu. The oxygen content of the CuSn material depends on the method of manufacture. In some embodiments, the oxygen content is: less than 100 ppm, less than 250 ppm, less than 500 ppm, less than 1000 ppm, less than 2500 ppm or less than 5000 ppm. In some embodiments, the CuSn material has a metallic purity of at least 99.9 %. In other embodiments, the CuSn material has a metallic purity of at least 99.99 %.

In the embodiments of the invention, e.g. using CuZnSn, CuZn and CuSn material, the preferred oxygen content is at least less than 1000 ppm.

In still yet another embodiment, the CuSn material further comprises an alkali compound, preferably a Na₂SO₃, Na₂SeO₃ or NaF content, ranging from 0 mol% to 25 mol%, preferably ranging from 5 mole percent to 20 mole percent. In one such embodiment, such material is formed as a three dimensional sputter target. In another such embodiment, the material is formed as a planar and/or tube-shaped target shape. In another embodiment, the CuSn material is mechanically alloyed or mechanically mixed to an alkali compound, preferably a sodium compound, in such a way that the content of the alkali metal in the target material ranges from 0 atomic percent to 25 atomic percent preferably from 5 atomic percent to 20 atomic percent. In one such embodiment, the material is formed as a planar and/or tube-shaped target shape.

In certain embodiments, the Cu₂ZnSn, CuZn or CuSn materials are formed in three dimensional shaped structures, such as a tube or tile, which are then applied to a target support to form a three dimensional sputter target. In such embodiments, the target support includes a support tube of stainless steel or a copper plate. In addition there are certain embodiments possible without any support, too. Sizes of the target support range from ca. 500-4000 mm in length and ca. 100-300 mm in width or ca. 70-180 mm in diameter.

In one embodiment of the Cu₂ZnSn, CuZn or CuSn materials, such materials exist as an alloy. In another embodiment, the Cu₂ZnSn, CuZn or CuSn materials exist as a single phase mixture of each element.

The various embodiments of the Cu₂ZnSn, CuZn or CuSn materials, which form the three dimensional sputter target, may be characterized by the grain size of the material. In one embodiment, the grain size is in the range of: 0.01 mm to 5 mm, 0.1 mm to 5 mm, 0.05 mm to 5 mm, 0.05 to 1 mm, 0.01 mm to 0.25 mm or subsets of ranges for each of the afore mentioned

In one embodiment, the three dimensional sputter target has at least one principle axis dimension greater than 500 mm, 1000 mm, 2500 mm or 4000 mm. In another embodiment, the three dimensional sputter target has at least one principle axis dimension ranging from: 500 mm to 4000 mm, 500 mm to 2500 mm, 500 mm to 1000 mm, 750 mm to 4000 mm, 750 mm to 3000 mm, 750 mm to 2500 mm, 1000 mm to 4000 mm or subsets of ranges for each of the afore mentioned ranges.

The three dimensional sputter target may have a variety of shapes including a tube, which may be hollow, a disk, a planar, which may consist of a plurality of tiles or cylinders. Also a combination of these shapes are possible. In one embodiment, the three dimensional sputter target is shaped as a tube having dimensions of: (i) a length ranging from 500 mm to 4000 mm, 500 mm to 1000 mm, 750 mm to 4000 mm, 750 mm to 3000 mm, 750 mm to 2500 mm, 1000 mm to 4000 nm; and (ii) a diameter ranging from: 100 mm to 200 mm, 100 mm to 150 mm or 150 mm to 200 mm; or subsets of ranges for each of the afore mentioned ranges for length and diameter.

In another embodiment, the three dimensional sputter target is shaped as a planar shape, having dimensions of: a length ranging from 500 mm to 4000 mm, 500 mm to 1000 mm, 750 mm to 4000 mm, 750 mm to 3000 mm, 750 mm to 2500 mm, 1000 mm to 4000 mm; (ii) a width ranging from: 70 mm to 300 mm, 70 mm to 150 mm or 150 mm to 250 mm; and (iii) thickness of 5 mm to 50 mm, 5 mm to 20 mm, 5 mm to 10 mm, 10 mm to 20 mm, 10 mm to 30 mm, 20 mm to 40 mm or 20 mm to 50 mm; or subsets of ranges for each of the afore mentioned ranges for length, width and thickness.

The above mentioned embodiments may consist out of an arrangement of tiles having dimensions of: (i) a length ranging from 100 mm to 300 mm, 150 mm to 300 mm, or 200 mm to 300 mm; and (ii) a thickness ranging from 3 mm to 30 mm, 10 mm to 30 mm, 20 mm to 30 mm, 20 mm to 40 mm or 20 mm to 50 mm; or subsets of ranges for each of the afore mentioned ranges for length and thickness.

The above mentioned embodiments may consist out of an arrangement of cylinders having dimensions of: (i) outer diameter ranging from 100 mm to 200 mm, 150 mm to 200 mm, or 100 mm to 150 mm; (ii) inner diameter ranging from 70 mm to 180 mm, 70 mm to 150 mm or 150 mm to 180 mm; (iii) length ranging from 100 mm to 250 mm, 100 mm to 750 mm, 100 mm to 500 mm, 500 mm to 750 mm or 100 mm to 4000 mm in special cases of usage of a single cylinder over full length; or subsets of ranges for each of the afore mentioned ranges for outer diameter, inner diameter and length.

The Cu₂ZnSn, CuZn or CuSn materials, of the three dimensional sputter target may be characterized by the material's microstructure. The material microstructure independently includes a cast microstructure, a sinter microstructure or a spray microstructure.

In one embodiment, the Cu₂ZnSn, CuZn or CuSn materials, of the three dimensional sputter target, may be characterized by the material's homogeneous microstructure. In such embodiments, at least 90 % of the grains of the material are of a size in a range of +/-70%, preferably +/-50% of a mean grain size range along the principal axis dimension of the material.

The mean grain size range of the Cu₂ZnSn, CuZn or CuSn materials, of the three dimensional sputter target, varies based on the process parameters used to generate the material. In one embodiment, the mean grain size range, for both the principal and radial axes, varies from: 0.05 mm to 0.5 mm, 0.05 mm to 0.25 mm or 0.05 mm to 0.1 mm. In other embodiments, the mean grain size range varies from: 0.5 mm to 5 mm, 0.5 mm to 3.5 mm or 0.5 mm to 2.5 mm.

In another embodiment, the Cu₂ZnSn, CuZn or CuSn materials, of the three dimensional sputter target, may be characterized by the material's homogeneous microstructure. In such embodiments, at least 90 % of the grains of the material are of a size in a range of +/-70%, preferably +/-50% of a mean grain size range along the axial dimension of the material and the radial dimension of the material. In such embodiments, the mean grain size range, along the axial dimension of the material, varies from 0.01 mm to 0.5 mm, 0.05 mm to 0.5 mm, 0.1 mm to 0.5 mm or 0.05 mm to 0.25 mm. In such embodiments, the mean grain size range, along the radial dimension of the material, varies from 0.005 mm to 0.5 mm, 0.005 mm to 0.05 mm or 0.01 mm to 0.05 mm.

In another embodiment, the Cu₂ZnSn, CuZn or CuSn materials, of the three dimensional sputter target, may be characterized by the material's homogeneous microstructure by the density measured throughout various locations of the material. In such embodiments, the material's density ranges from: 80-99 % of theoretical density, 85-99 % of theoretical density, 90-99 % of theoretical density, 95-99 % of theoretical density or 98-99 % of theoretical density. In other embodiments, the material's density is: greater than 95 % of theoretical density, greater than 98 % of theoretical density or greater than 99 % of theoretical density.

The three dimensional sputter targets made of CuSn, CuZn, and Cu₂ZnSn, may be produced using various thermal and mechanical manufacturing technologies, and made available for sputtering technology. In one embodiment, the three dimensional sputter target materials may be made by casting techniques Cu is melt mixed with one or more of Zn and Sn at a temperature above the melting point of the mixture, e.g., 550-1100° C; the mixture is transferred to a preheated mold; and cooled to thereby form a three dimensional shaped structure. The three dimensional shaped structure is then applied to a target support to form the three dimensional sputter target.

In another embodiment, the three dimensional sputter target materials may be made by mixing Cu powder mixed with one or more of Zn and Sn powder, followed by compressing the mixture to thereby form a three dimensional shaped structure. In one embodiment, an alkali compound powder, preferably a Na₂SO₃, Na₂SeO₃ or NaF powder, is added to the powder mixture of Cu with one or more of Zn and Sn, to thereby by form a powder mixture comprising a powder mixture of Cu with one or more of Zn and Sn and the alkali compound. The compressing step may be accomplished by axial compressing or cold-isostatic compressing. In such embodiments, the compressing step can be performed at pressures ranging from 0.4 to/cm² to 2 to/cm², and temperatures ranging from 20° C to 380° C. In one such embodiment, the compressed mixture may be sintered subsequently. The sintering step may be accomplished by vacuum sintering. In some embodiments, the sintering step may be performed at temperatures ranging from 400° C to 750° C.

In another embodiment, the three dimensional sputter target materials may be made by mixing Cu with one or more of Zn and Sn. The mixture is sprayed onto a rotating target support to thereby form three dimensional sputter target. In one such embodiment, the spraying is accomplished by a technique including cold gas spraying, plasma spraying or arc spraying.

In still yet another embodiment, the three dimensional sputter target is made by melting Cu with one or more of Zn and Sn and spraying the melted mixture towards a rotating target support to thereby form three dimensional sputter target. The spraying step is performed in a vacuum or an inert gas.

All examples presented below results in tile- or tube-shaped sputter target materials. The structures produced are structures including alloy phases or fine-grained one-phase structures of the elements, Cu, Zn, Sn, such that sputtering of said targets results in a homogeneous Cu₂ZnSn layer.

The mixture or alloy for producing a three dimensional sputter target has a binary combination of the three elements of Cu, Zn and Sn, preferably a mixture with the basis of CuSn or CuZn, or a tertiary combination of the three elements Cu, Zn and Sn, preferably a mixture with the basis of CuSnZn or CuZnSn. Within the binary or tertiary combination Cu is the main content and the added elements of Zn and/or Sn create a metallurgical formula of Cu-combinations containing Sn and/or Zn. Minor, not relevant impurities might be also in these Cu-combination containing Sn and/or Zn.

### Example 1

The raw materials, Cu and Zn, were melted jointly at an atomic mixing ratio of 1:1 in a vacuum induction melting furnace and then decanted into a graphite ingot mould at slightly above the melting temperature. The graphite ingot mould was pre-heated to 200° C and the solidification proceeded slowly. The solidification was performed by cooling the graphite ingot mould using no additional cooling media like compressed air or water. In one instance of the example, the graphite ingot mould was isolated using a thermal insulating material. This method was used to produce tiles of dimensions 200 mm x100 mm x10 mm and tube-shaped segments of dimensions 160 mm x135 mm x 250 mm with a cast structure. The resulting microstructure was homogeneous over length and thickness with grain size in the range of: 0.1 mm to 5 mm and an oxygen content <100 ppm. This oxygen content was measured at different positions of the tiles and tube-shaped segments. The mean grain size range was 1.5 mm to 3.5 mm. The measured density of the tile segments and tube-shaped segments was greater than 99 % of the theoretical density measured at various locations of the segments. The microstructure contained 50 at. % of Zn ± 2 at. % with the balance being Cu. The tiles were bonded to a Cu backing plate to be ready for installation on a sputtering cathode. The tube-shaped segments were bonded on a support tube, e.g. made of stainless steel, resulting in a rotatable sputtering target.

### Example 2

The raw materials, Cu and Sn, were melted jointly at an atomic mixing ratio of 1:1 in a vacuum induction melting furnace and then decanted into a graphite ingot mould at slightly above the melting temperature. The graphite ingot was pre-heated to 200° C and the solidification proceeded slowly. This method was used to produce both tiles of dimensions 200 mm x100 mm x10 mm and tube-shaped segments of dimensions 160 mm x 135 mm x 250 mm with a cast structure. The resulting microstructure was homogeneous over length and thickness with the grain size in the range of: 0.1 mm to 5 mm and an oxygen content < 100 ppm. This oxygen content was measured at different positions of the tiles and tube-shaped segments. The mean grain size range was 1.5 mm to 3.5 mm. The measured density of the tile segments and tube-shaped segments was greater than 99 % of the theoretical density measured at various locations of the segments. The microstructure contained 50 at. % of Zn ± 2 at. % with the balance being Cu. The tiles were bonded to a Cu backing plate to be ready for installation on a sputtering cathode. The tube-shaped segments were bonded on a support tube, e.g. made of stainless steel, resulting in a rotatable sputtering target.

### Example 3

The raw materials, Cu, Zn, and Sn, were melted jointly at an atomic mixing ratio of 2:1:1 in a vacuum induction melting furnace and then decanted into a graphite ingot mould at slightly above the melting temperature. The graphite ingot mould had wall thickness of 40 mm and should be pre-heated to 400° C and the solidification proceeded slowly. The cooling process took place under vacuum. This process resulted in a material having a homogeneous microstructure with the grain size in the range of: 0.1 mm to 5 mm and an oxygen content < 100 ppm. This oxygen content was measured at different positions of the tiles and tube-shaped segments. The mean grain size range was 1.5 mm to 3.5 mm. The measured density of the tile segments and tube-shaped segments was greater than 98 % of the theoretical density measured at various locations of the segments. The material contained 25 at. % Zn, ± 2 at. %, 25 at. % Sn, ± 2 at. %, and the balance being Cu. This method was used to produce both tiles of dimensions 200 mm x 100 mm x 10 mm and tube-shaped segments of dimensions 160 mm x 135 mm x 250 mm with a cast structure. The tiles were bonded to a Cu backing plate to be ready for installation on a sputtering cathode. The tube-shaped segments were bonded on a support tube, e.g. made of stainless steel, resulting in a rotatable sputtering target.

### Example 4

The raw materials, Cu, Zn, and Sn, were melted jointly at an atomic mixing ratio of 2:1:1 and then decanted in a centrifugal casting machine with a preheated steel mold of 300° C. This process resulted in a material having a homogeneous microstructure with the grain size in the range of: 0.1 mm to 3 mm and an oxygen content < 250 ppm. This oxygen content was measured at different positions of the tube-shaped segments. The mean grain size range was 0.5 mm to 2.5 mm. The measured density of the tube-shaped segments was greater than 98 % of the theoretical density measured at various locations of the segments. The material contained 25 at. % Zn, ± 2 at. %, 25 at. % Sn, ± 2 at. %, and the balance being Cu. The method was used to produce tube-shaped segments of dimensions 170 mm x 130 mm x 500 mm with a cast structure. The tube-shaped segments were after-worked externally and internally using chip removal and polishing technology. The tube-shaped segments were bonded on a support tube, e.g. made of stainless steel, as sputtering target.

### Example 5

The elements, Cu, Zn, Sn, were melted in a crucible and then decanted using a continuous casting facility with a feed rate of 10 mm/min. This method was used to produce both planar and tube-shaped profiles with a cast structure. Depending on composition of elements only small segments are possible due to the brittleness of the material: tube segments having dimensions of length of 250 mm, inner diameter of 135 mm and outer diameter of 165 mm or planar segments having dimensions of 150 mm x100 mm x 15 mm. The microstructure was homogeneous with the grain size in the range of: 0.1 mm to 5 mm and an oxygen content < 300 ppm. This oxygen content was measured at different positions of the tube-shaped and planar-shaped segments. The mean grain size range was 1.5 mm to 3.5 mm. The measured density of the tube-shaped and planar-shaped segments was greater than 99 % of the theoretical density measured at various locations of the segments. The material contained 25 at. % Zn, ± 2 at. %, 25 at. % Sn, ± 2 at. %, and the balance being Cu. The tiles were bonded to a Cu backing plate as a sputtering target. The tube-shaped segments were bonded on a support tube, e.g. made of stainless steel, as a sputtering target.

### Example 6

Metallic powders Cu, Zn, Sn of grain size 50-250 µm were mixed and compressed through an axial or cold-isostatic compression technique with an applied pressure of 1.5 to/cm². Tiles and tube-shaped segments were pressed. The densities achieved by this means are sufficient to allow the resulting material to be handled. The resulting structure was fine-grained and the mean grain size in the range of: 0.05 mm to 0.25 mm and an oxygen content < 500 ppm. This oxygen content was measured at different positions of the tiles and tube-shaped segments. The measured density of the tile segments and tube-shaped segments was greater than 81 % of the theoretical density measured at various locations of the segments. The powder grains that are present are non-alloyed. Both tiles and tube-shaped segments were produced which are then applied by bonding technique to a Cu backing plate or a stainless steel support tube. In one instance of this example, the tiles or segments were compressed directly onto a backing plate, a backing plate segment or a support tube. For a sufficient connection to be established, the backing plate/the backing plate segment/support tube was provided with a modified surface, e.g. interlocking.

### Example 7

Metallic powders Cu, Zn, Sn of grain size 50-250 µm were mixed, pre-compressed through compression technology with an applied pressure of 1 to/cm², and then sintered through vacuum sintering technology at sintering conditions 450° C for 5 hours. This method allowed both tiles and tube-shaped segments with a fine-grained homogeneous sinter-microstructure the grain size in the range of: 0.05 mm to 1 mm and an oxygen content < 500 ppm. This oxygen content was measured at different positions of the tiles and tube-shaped segments. The mean grain size range was 0.05 mm to 0.5 mm. In some instances of this example, the material exhibited initial alloying of the metallic powders. In some other instances, the material exhibited complete alloying of the metallic particles evidenced by a homogeneous distribution of each alloying element within a microscopic range. The tiles were bonded to a Cu backing plate as a sputtering target. The tube-shaped segments were bonded on a support tube, e.g. made of stainless steel, as sputtering target.

### Example 8

An alloy powder Cu2ZnSn was produced, e.g. through a vacuum atomisation procedure. The alloy powder was then compressed at pressure 1 to/cm² and sintered in a vacuum at sintering conditions 540° C for 3 hours. This method allows both tiles and tube-shaped segments with a fine-grained homogeneous sinter-microstructure exhibited by the mean grain size in the range of: 0.05 mm to 0.35 mm showing complete alloying of the elements. The tiles were bonded to a Cu backing plate as a sputtering cathode. The tube-shaped segments were bonded on a support tube, e.g. made of stainless steel, as a sputtering target.

### Example 9

Mixed elemental metallic powders Cu, Zn, Sn or alloy powder Cu₂ZnSn of particle range of 10 to 100 µm were applied to a rotating substrate through a cold gas spraying technique. This means mainly allows tube-shaped targets with a fine-grained structure to be produced. The homogeneous pancake-like microstructure showed a mean grain size in axial direction ranging from 0.04 mm to 0.2 mm, and a mean grain size in radial direction ranging from 0.005 mm to 0.02 mm. The oxygen content was 500 ppm which was measured at different positions of the tube-shaped segments. The measured density of the tube-shaped segments was greater than 93 % of the theoretical density measured at various locations of the segments. The substrate consists, e.g., of a stainless steel tube and serves as target support. Thus the resulting target consists of a stainless steel tube carrier length 550 mm, outer diameter of 133 mm, and a target outer diameter of 145 mm.

### Example 10

Cu wire, Zn wire, and Sn wire of diameter 1.6 mm were fed to an arc spraying facility of a specialized design. The wires were melted through the arc, disintegrated into droplets through the propellant gas, and accelerated towards the rotating substrate. This means mainly allows tube-shaped targets with a fine-grained structure to be produced. The pancake-like homogeneous microstructure showed a mean grain size in axial direction ranging from 0.05 mm to 0.3 mm, and a mean grain size in radial direction 0.01 mm to 0.05 mm. If used in an atmosphere, the structure includes an oxygen fraction of 3500 ppm. This oxygen content was measured at different positions of the tube-shaped segments. If used in a protective gas or at low atmospheric pressure, the oxygen content can be reduced by 50 %. The substrate consists, e.g., of a stainless steel tube and serves as target support. This results in a target consisting of a stainless steel tube carrier having a length of 550 m, outer diameter of 133 mm, and a target material outer diameter of 139 mm. Similar results are possible by using a cord wire with Cu as outside material and ZnSn powder core.

### Example 11

Cu, Zn, and Sn powders of particle range of 10 to 150 µm were mixed and sprayed in a plasma spraying facility. In the process, the powder particles were melted in an Ar plasma and accelerated towards a rotating substrate. This means mainly allows tube-shaped targets with a homogeneous fine-grained structure to be produced. The microstructure is pancake-like and consists of almost elementary Cu-, Zn-, Sn-phases. The mean grain size in axial direction ranges from 0.05 mm to 0.25 mm, the grain size in radial direction ranges from 0.01 mm to 0.05 mm. If used in an atmosphere, the structure includes an oxygen fraction of 5000 ppm. This oxygen content was measured at different positions of the tube-shaped segments. If used in a protective gas or at low atmospheric pressure, the oxygen content can be reduced by 50 %. The substrate consists, e.g., of a stainless steel tube and serves as target support. The target consists of a stainless steel tube carrier having a length of 550 m, outer diameter of 133 mm, and a target outer diameter of 142 mm.

### Example 12

An alloy powder Cu₂ZnSn of particle range of 10 to 150 µm was sprayed in a plasma spraying facility. In the process, the powder particles were melted in an Ar plasma and accelerated towards a rotating substrate. This means mainly allows tube-shaped targets with a homogeneous, pancake-like, fine-grained structure to be produced. The mean grain size in axial direction ranged from 0.05 mm to 0.25 mm, and the mean grain size in radial direction ranged from 0.01 mm to 0.05 mm. The microstructure consists of CuZnSn alloy particles. If used in an atmosphere, the structure includes an oxygen fraction of 4500 ppm. This oxygen content was measured at different positions of the tube-shaped segments. If used in a protective gas or at low atmospheric pressure, the oxygen content can be reduced by 50 %. The substrate consists, e.g., of a stainless steel tube and serves as target support. The target consists of a stainless steel tube carrier having a length of 550 mm, outer diameter of 133 mm, and a target material of outer diameter of 139 mm

### Example 13

Raw materials Cu, Zn, and Sn were melted at an atomic mixing ratio of 2:1:1 and atomised from the melted material towards a rotating substrate in a vacuum or protective gas at a process temperature slightly above the melting point of the alloy. The process is under atomization pressure of 1 bar, the rotary speed of the carrier tube is 50 rpm, and the longitudinal feed rate is 150 mm/min. This results in a homogeneous microstructure with mean grain size in axial direction ranging from 0.1 mm to 0.3 mm, and a mean grain size in radial direction ranging from 0.01 mm to 0.05 mm. The alloy had an oxygen content ranging from 300 ppm to 500 ppm and was measured at different positions of the tube. The measured density of the tube ranged from 89-92 % of the theoretical density measured at various locations of the tube. The material contained 25 at. % Zn, ± 2 at. %, 25 at. % Sn, ± 2 at. %, and the balance being Cu. The substrate/carrier tube consists, e.g., of a stainless steel tube and serves as target support.

### Example 14

An alloy powder Cu₂ZnSn was produced, e.g. through a vacuum atomization procedure. The alloy powder was mixed with 10 mol% of a powder of sodium sulphite Na₂SO₃ and compressed at 1.5 to/cm² and sintered in a vacuum at 600° C. This method allows both tiles and tube-shaped segments with a fine-grained sintering structure showing complete alloying of the elements to be produced. The homogeneous microstructure shows a mean grain of Cu₂ZnSn in the range of 0.05 to 0.15 mm, a mean grain size Na₂SO₃ ranging from 0.1 mm to 0.75 mm. The tiles of size 200 mm x 100 mm were bonded to a Cu backing plate as a sputtering target. The tube-shaped segments of having inner diameter of 135 mm, outer diameter of 160 mm, and length of 100 mm, were bonded on a support tube, e.g., made of stainless steel, as sputtering target. The measured density of the tile and tube-shaped segments ranged from 90-93 % of the theoretical density measured at various locations of the segments. The Na₂SO₃ was homogeneously distributed throughout the alloy. Other alkali compounds like Na₂SeO₃ or NaF or the in detail above mentioned Na₂SO₃ (with content of 10 mol %) could for example also range from 0 mol. % to 25 mol. %, preferably range from 5 mol. % to 20 mol. %, in the alloy powder Cu₂ZnSn after mixture to create further possible embodiments.

## Claims

1. A three dimensional sputter target comprising:
a CuZnSn material having a Cu content ranging from 40 atomic percent to 60 atomic percent;
a Zn content ranging from 20 atomic percent to 30 atomic percent; and
a Sn content ranging from 20 atomic percent to 30 atomic percent, wherein the three dimensional sputter target has at least one principal axis dimension greater than 500 mm and the CuZnSn material has a grain size ranging from 0.005 mm to 5 mm.

2. A three dimensional sputter target comprising:
a CuZn material having a Cu content ranging from 40 atomic percent to 60 atomic percent; and
a Zn content ranging from 40 atomic percent to 60 atomic percent, wherein the three dimensional sputter target has at least one principal axis dimension greater than 500 mm and the CuZn material has a grain size ranging from 0.005 mm to 5 mm.

3. A three dimensional sputter target comprising:
a CuSn material having a Cu content ranging from 40 atomic percent to 60 atomic percent; and
a Sn content ranging from 40 atomic percent to 60 atomic percent, wherein the three dimensional sputter target has at least one principal axis dimension greater than 500 mm and the CuSn material has a grain size ranging from 0.005 mm to 5 mm.

4. The three dimensional sputter target according to any of claims 1-3, wherein the material is an alloy composition.

5. The three dimensional sputter target according to any of claims 1-3, wherein the material is a single phase mixture of each element.

6. The three dimensional sputter target according to any of claims 1-5, wherein the three dimensional sputter target has a shape comprising a tube, a disk, a plane, a tile or a cylinder.

7. The three dimensional sputter target according to claim 6, wherein the three dimensional sputter target comprises a tube shape having a length ranging from 500 mm to 4000 mm and a diameter ranging from 100 mm to 200 mm.

8. The three dimensional sputter target according to claim 6, wherein the three dimensional sputter target comprises a planar shape having a length ranging from 500 mm to 4000 mm, a width ranging from 70 mm to 300 mm and a thickness ranging from 3 mm to 50 mm.

9. The three dimensional sputter target according to claim 6, wherein the three dimensional sputter target comprises a planar shape having a length ranging from 500 mm to 4000 mm, a width ranging from 70 mm to 300 mm and a thickness ranging from 3 mm to 50 mm comprised of a plurality of tiles, each tile having a length ranging from 100 mm to 300 mm, a width ranging from 70 mm to 300 mm and a thickness ranging from 3 mm to 50 mm.

10. The three dimensional sputter target according to claim 6, wherein the three dimensional sputter target comprises a cylinder shape comprised of a plurality of segments, wherein the three dimensional target has an outer diameter ranging from 100 mm to 200 mm, an inner diameter ranging from 70 mm to 180 mm and a length ranging from 500 mm to 4000 mm and where each segment has an outer diameter ranging from 100 mm to 200 mm, an inner diameter ranging from 70 mm to 180 mm and a length ranging from 100 mm to 750 mm.

11. The three dimensional sputter target according to any of claims 1-10, wherein the material comprises a homogeneous microstructure.

12. The three dimensional sputter target according to claim 11, wherein at least 75 % of the grains of the material comprise a size in a range of +/-70%, preferably +/-50% of a mean grain size range in the principal axis dimension.

13. The three dimensional sputter target according to claim 12, wherein the mean grain size ranges from 0.05 mm to 0.5 mm.

14. The three dimensional sputter target according to claim 12, wherein the mean grain size ranges from 0.5 mm to 5.0 mm.

15. The three dimensional sputter target according to any of claims 11-14, wherein the homogeneous microstructure is **characterized by** the material density ranging from 80-99 %, 85-99 %, 90-99 %, 95-99 % or 98-99 % each of theoretical density.

16. The three dimension sputter target according to any of claims 1 to 15, wherein the oxygen content is less than 100 ppm, less than 250 ppm, less than 500 ppm, less than 1000 ppm, less than 2500 ppm or less than 5000 ppm, preferably at least less than 1000 ppm.

17. A planar and/or tube-shaped target material according to claims 1-16, wherein an alkali compound, preferably a sodium compound, has a content of the alkali metal in the target material ranging from 0 at. % to 25 at. %, preferably from 5 at. % to 20 at. %.

18. A three dimensional sputter target according to claims 1-16 or a planar and/or tube-shaped target material according to claim 17 further comprising an alkali compound, preferably a Na₂SO₃, Na₂SeO₃ or NaF content, ranging from 0 mol. % to 25 mol. %, preferably ranging from 5 mol. % to 20 mol. %.

19. A method of producing the three dimensional sputter target according to any of claims 1-18, comprising:
melt mixing Cu with one or more of Zn and Sn at a temperature above a melting point of the mixture;
transferring the mixture to a preheated mold; and
cooling the mixture to thereby form a three dimensional shaped structure.

20. The method of claim 19, further comprising applying the three dimensional shaped structure to a target support to form the three dimensional sputter target.

21. A method of producing the three dimensional sputter target according to any of claims 1-18, comprising:
providing a powder mixture of Cu with one or more of Zn and Sn; and
compressing the powder mixture to thereby form a three dimensional shaped structure, wherein the compressing is accomplished by axial compressing or cold-isostatic compressing.

22. The method according to claim 21, further comprising sintering the compressed mixture.

23. The method according to claim 21 or claim 22, further comprising the step of adding an alkali compound powder, preferably a Na₂SO₃, Na₂SeO₃ or NaF powder, to the powder mixture of Cu with one or more of Zn and Sn, to thereby generate a powder mixture of Cu with one or more of Zn and Sn and the alkali compound powder.

24. The method according to claim 23, wherein the powder mixture of Cu with one or more of Zn and Sn and the alkali compound powder are mechanically alloyed or mechanically mixed.

25. A method of producing the three dimensional sputter target according to any of claims 1-18, comprising:
providing a mixture of Cu with one or more of Zn and Sn; wherein said mixture has a powder form or a wire form or is an alloy; and
spraying the mixture onto a rotating target support to thereby form three dimensional sputter target, wherein the spraying is accomplished by a technique selected from the group consisting of: cold gas spraying, plasma spraying or arc spraying.

26. A method of producing the three dimensional sputter target according to any of claims 1-18 comprising:
melting Cu with one or more of Zn and Sn;
spraying the melted mixture towards a rotating target support to thereby form three dimensional sputter target, wherein the spraying is performed in a vacuum or an inert gas.

27. The method of producing the three dimensional sputter target according to any of claims 19-26, wherein the mixture has a binary combination of the three elements of Cu, Zn and Sn, preferably a mixture with the basis of CuSn or CuZn, or a tertiary combination of the three elements Cu, Zn and Sn, preferably a mixture with the basis of CuSnZn or CuZnSn.
